# EUROPEAN PATENT SPECIFICATION

(11) **EP 0 229 726 B1**
(45) Date of publication and mention of the grant of the patent: **16.06.1993**
(21) Application number: 87300348.7
(22) Date of filing: 16.01.1987
(51) Int. Cl.: G05F 1/46, H03K 19/00, H03K 19/086

(54) **Delay regulation circuit**
Schaltung zum Angleichen der Signalverzögerungszeiten
Circuit de régulation des temps de propagation

(30) Priority: 16.01.1986 US 819789; 23.07.1986 US 889439
(43) Date of publication of application: 22.07.1987
(73) Proprietor: TANDEM COMPUTERS INCORPORATED, Cupertino California 95014-2599 (US)
(72) Inventor: Chengson, David P., Mountain View California 94044 (US); Wang, William H., Saratoga California 95070 (US)
(74) Representative: Huntingford, David Ian

(56) References cited:
- EP-A- 0 046 482
- EP-A- 0 151 875
- WO-A-85/02955
- IBM TECHNICAL DISCLOSURE BULLETIN, vol. 19, no. 2, July 1976, pages 500-501, IBM Corporation, New York, US; W.M. CHU: "On-chip constant-current compensator"

## Description

The present invention relates generally to integrated semiconductor digital circuits, and more particularly to regulation of signal propagation delay presented by individual ones of a number of electronic circuits formed on an integrated circuit chip.

It is well known that the speed of electronic circuits (i.e., the propagation delay exhibited by a gate of an electronic digital circuit) formed on a semiconductor circuit chip can vary from chip to chip due to process variations. Typically, such gate delays can vary as much as 30% from chip to chip, and must be taken into account by designers. For example, a designer must be aware of the fact that when his or her design is fabricated in integrated circuit form, one particular chip may operate faster (have smaller gate delays) or slower (have greater gate delays) than another identical chip. The designer must be aware of the maximum and minimum limits of gate delay variations, and take them into account to make sure that digital signals converge at the inputs of any particular digital gate when they should, and/or remain long enough to be acted upon.

Of course, circuit manufacturers can tighten their specifications to reduce process variations experienced during integrated circuits fabrication. However, this solution can be very expensive. Accordingly, a happy medium is reached between a circuit speed variation that can be tolerated and fabrication expense. The result: Speed of the circuitry is reduced; good circuit design practice requires that the circuits of the chip be designed with operating speeds at the lower end of the variation range - even if not always true on an individual chip basis.

There have been techniques proposed that provide dynamic regulation of an electronic circuit's delay. These techniques, however, are generally limited to controlling small circuit operating parameters in the internal switching and amplifying sections of the gate. It has been found, however, that process variations, insofar as gate delays are concerned, often affect the output stages of a gate. This is because a digital gate typically drives a number of other gates, and must, therefore, be capable of sourcing (or sinking) relatively large output currents during output transitions. Process variations can cause concomitant variations in the impedance (primarily capacitance) seen by these output stages which affect the time it takes for the gate's output to change from one state to another.

There is known from EP-A-0 046 482 a circuit for use in varying the power in logic or array circuits so as to minimise chip to chip speed differences caused by variations of power supply, constructional variations, and the like. A delay regulator in the circuit generates a signal indicative of chip performance and compares this with a system-wide periodic reference signal or clock. The comparison creates a signal which controls the power in the logic/array circuitry on the chip to thereby control the performance. By connecting the reference signal to all of the chips in the system, all of the chips will have the same relative performance (gate speed).

It is an object of the present invention to provide an improved means for regulation of signal propagation delay by electronic circuits on an integrated circuit chip.

The present invention provides a post-processing technique for adjusting gate delays to compensate for process variations by static regulation of the output current range of an electronic circuit formed on an integrated circuit chip. The technique narrows the range of signal propagation delays that must be tolerated by a designer, allowing the overall circuit regulated by the present invention to operate at higher circuit speeds.

In accordance with the present invention, there is provided an apparatus formed on a semi-conductor chip fabricated to carry a plurality of electronic circuits, each of which includes a respective output stage having an output terminal for providing an output current thereat in response to an input signal applied to that output stage, the apparatus being adapted for regulation of the signal propagation delay exhibited by each of the electronic circuits and comprising:
for each said output stage, a first circuit means coupled to that output stage and operable to limit the output current range in response to a common limit signal;
a second circuit means coupled to each of the first circuit means and presettable to provide a selected one of a number of reference signals as the common limit signal to all of those first circuit means; and
each output stage including a third circuit means operably coupled to that output stage, in series circuit configuration with the first circuit means associated with that output stage, and adapted to provide an increased current handling capability during high to low transitions of the output current of that output stage.

In a preferred embodiment of the invention, the second circuit means comprises a digital-to-analog circuit (DAC) which is formed on the integrated circuit chip carrying the electronic circuit or circuits to be regulated. The DAC is constructed so that it can be programmed to selectively provide said one of said number of common reference signals (voltages). The common reference signal is coupled to a control device (the third circuit means) that forms a part of the output stage of each of the regulated gate or gates, operating in response to the reference signal to set the gate's output current range and, thereby, the switching speed (primarily, the low to high transition) of the gate.

Programming the DAC may be accomplished in a variety of ways. However, the preferred embodiment of the invention uses emitter-coupled transistor pairs operating in a current-switching mode. The base circuit of one transistor of each pair is brought out to an external contact point disposed on the circuit package containing the invention. Any or all of the pins may be mechanically connected to a voltage to cause current to be carried through one or the other of the transistors of each pair, producing a summed current that is indicative of the programming, and used to produce the reference signal.

In operation, an integrated circuit chip that includes the present invention is tested to determine the gate delays of the gates making up the integrated circuit. Although within the manufacturer's guaranteed specifications, the delay may be out of the range desired. Accordingly, once so tested, one or more of the contact pins are connected or left alone as necessary to cause the (on-board) digital-to-analog circuit to produce a reference signal that, through the control device, adjusts the current-carrying capability of the gate's output stage.

As an example: The present invention is developed to regulate digital gates formed using emitter coupled (ECL) technology. Such gates typically use an emitter-follower configuration output. As noted above, process variations can affect and vary the impedance the gate's output stage must operate into, causing a gate to work into a larger impedance in chips produced on one occasion, and the same gate to a smaller impedance when fabricated on another occasion. Thus, the gate, designed to have a predetermined current with an optimum output impedance will exhibit a greater signal propagation delay in the former case than in the latter. The solution provided by the present invention is to give the output stage greater current-handling capability in the former case, and to reduce the current-handling capability in the latter case.

One advantage of the present invention is that circuits formed on integrated circuit chips can be designed to much tighter timing tolerances with no increase in manufacturing costs. In addition, the ability to design an integrated circuit with much tighter timing produces higher operating speeds.

The invention is described further hereinafter, by way of example only with reference to the accompanying drawings, in which:
Fig. 1 is a block diagram representation of an arrangement in accordance with the present invention, illustrating the delay regulation circuit to adjust the signal propagation delay exhibited by certain of the electronic circuits formed on an integrated circuit chip;
Fig. 2 is a circuit diagram of the digital-to-analog converter, shown in Fig. 1, used to generate the reference signal (V_{ref});
Fig. 2A illustrates an integrated circuit package, showing the control pins that are made available at the top of the package for programming the digital-to-analog circuit of the present invention to obtain a desired reference voltage;
Fig. 3 is a circuit representation of an output stage of a representative electronic circuit regulated by the present invention, showing control devices in the form of current sources that set the range of the output current of the electronic circuit in response to the reference signal;
Fig. 4 illustrates in more detail the output stage of Fig. 3, showing the active pull-down circuit that operates to sharpen falling edges of the output signal produced by the stage; and
Fig. 5 is an illustration of a representative test circuit used to determine the delay of the electronic circuits formed on an integrated circuit chip carrying the test circuit.

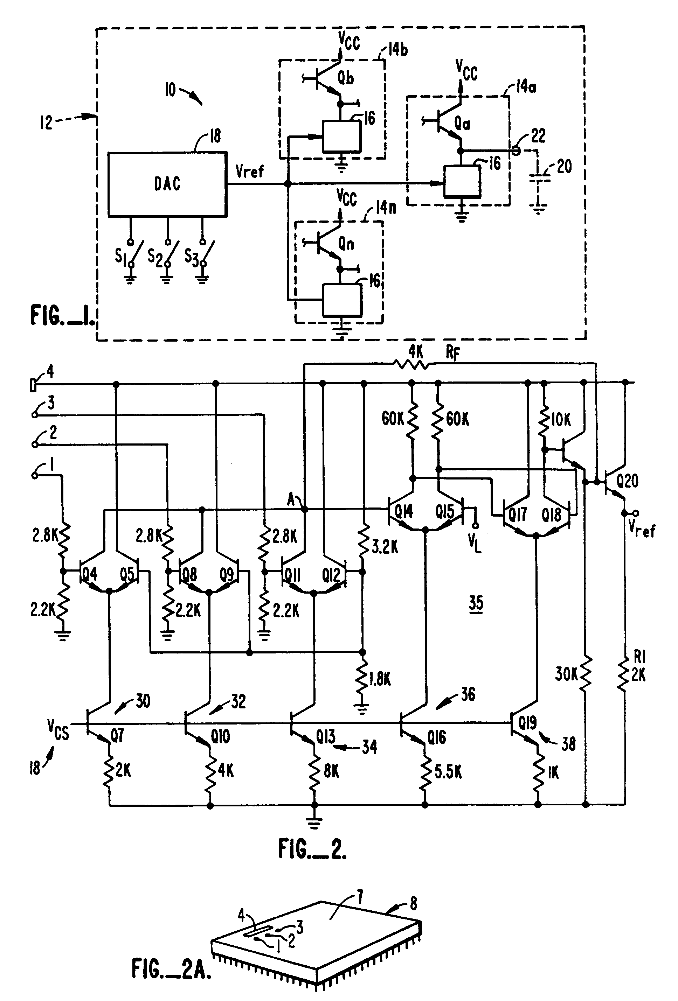

In Fig. 1, the delay regulation circuit of the present invention, designated generally by the reference numeral 10, is diagrammatically illustrated as being formed on a semiconductor substrate or integrated circuit "chip" 12, together with a plurality of digital electronic circuits or logic "gates" 14a, 14b ... 14n. The gates 14a, 14b ... 14n can take a number of forms, such as NAND gates, NOR gates, and inverters; combined they can form flip-flops, registers, etc. Gates 14a, 14b ... 14n represent a variety of such circuit elements and, although only a few are shown in Fig. 1, the gates 14a, 14b ... 14n can be very large in number. However, so far as is important here, they all have one thing in common: An output stage that includes an emitter-follower type terminal. Thus, as Fig. 1 illustrates, the gates 14a, 14b ... 14n all have output stages that include emitter-follower transistors Qa, Qb, ... and Qn, respectively.

The delay regulation circuit 10 includes a control device 16 that is situated in the emitter-circuit of each of the output transistors Qa - Qn. A digital-to-analog converter (DAC) 18 operates to supply a common reference voltage V_{ref} that can be set to a particular value by operation of switches S₁, S₂ and S₃.

During operation, the output stages of the various electronic circuits 14a - 14n must contend with certain amounts of output impedance, often capacitive in nature. This is illustrated in phantom in Fig. 1 by the capacitor 20 that is connected to the output lead 22 of gate 14a. The other electronic circuits 14b - 14n would have similar output impedances to work into, although not specifically shown.

As explained above, it is this output impedance (capacitance 20) that causes, in large part, the signal propagation delays experienced from chip to chip. (As used herein, signal propagation delay refers to that amount of time beginning with the application - rising edge or falling edge - of a signal to an electronic circuit, and ending with the output of that signal - falling edge or rising edge - from the electronic circuit.) Process variations affect not only the make-up of the individual circuits 14a - 14n themselves, but also the impedances, such as the capacitance 20, into which the electronic circuits work. A significant component of the speed of the circuit is the amount of current (i.e. the rate of charge transfer per unit time) that the circuit is capable of handling. The speed of the circuit, therefore, depends upon how fast the output capacitance 20 can be charged and/or discharged. Certain integrated circuit chips 12 may undergo processes that produce electronic circuits 14a - 14n capable of much faster charge/discharge times than other circuit processes.

Thus, it is a primary objective of the present invention to provide means for post-process adjustment of the current-handling capability of output circuits to, in turn, adjust the signal propagation delay that may be associated with the gates 14a, 14b, ... 14n carried by an integrated circuit chip 12. For example, a pair of integrated circuit chips 12 may be produced at different times, resulting in one chip having a propagation delay of t1, while the other has a propagation delay of t2, where t1 is greater than t2. The present invention is capable of operating on both types. Thus, the faster chip 12 (the one having the delay time of t2) can be slowed down by decreasing the capability of the output circuit to transfer charge, i.e., to decrease its current-handling capability. In similar fashion, the integrated circuit chip exhibiting the slower signal propagation delay time t1 can have its speed increased by increasing the amount of charge its output stages can transfer per unit time, i.e., increasing its current-handling capability. This is the function of the control devices 16.

In operation, the delay times of the electronic circuits 14a - 14n are determined in a manner that will be discussed more fully below. Armed with this information, a further determination can be made as to whether the circuit delays should be adjusted. If so, switches S1, S2 and S3 can be opened or closed, as necessary, to generate a common reference signal V_{ref} that corresponds to a control circuit 16 operation that achieves the desired adjustment. Upon receipt of V_{ref}, the control devices 16 will be set to a corresponding state that either increases or decreases the current-handling capability of the output stages of the respective electronic circuits 14a - 14n to adjust the delay as indicated by the initial determination of delay times.

Turning now to Fig. 2. the circuit diagram of the DAC 18 is illustrated. DAC 18 is shown as being formed by emitter-coupled transistor pairs Q4/Q5, Q8/Q9 and Q11/Q12. One transistor of each pair has a collector lead that connects to a current node A, and a base lead that is connected to a resistive voltage divider circuit that, in turn, connects to an external contact 1, 2, 3. The other transistor of each pair connects to a supply voltage V_{cc}. The emitters of each pair Q4/Q5, Q8/Q9 and Q11/Q12 connect to current sources 30, 32 and 34. respectively, which supply the current (set by the bias voltage V_{cs} applied to the base leads of the transistors Q7, Q10 and Q13) switched by each transistor pair.

The switches S1, S2, S3 are implemented using the external contacts 1, 2, 3, which are brought out to an accessible location of the packaging containing the invention. Thus, for example, as illustrated in Fig. 2A, the external contacts 1, 2, 3 appear on a top surface 7 of the integrated circuit package 8 and, together with the external contact 4 that connects to V_{cc}, operate to implement a method of programming DAC 18. Thus, for example, depending upon whether the external contacts 1, 2, 3 are left undisturbed and allowed to float or are electrically connected to the external contact 4 (thereby connecting the associated base circuit of one of the transistors Q4, Q8, Q11 to V_{cc} via 2.8K Ohm resistors) they will function to switch the current sources 30-34 through one or the other of the transistors of the corresponding emitter-coupled pairs Q4/Q5, Q8/Q9. The binary weighting of the current produced by the current sources 30-34, depending upon the current path selected, will produce a total current that is summed at the node current A and applied to a base lead of transistor Q14. With transistor Q15, transistor Q14 forms an emitter-coupled pair that functions as the input of a differential amplifier 35 that includes the emitter-coupled pair Q17/Q18 and current sources 36 and 38. The differential amplifier 35 amplifies the current received at the base lead of transistor Q14 to form the reference signal V_{ref} which is amplified by transistor Q20 before being coupled to control circuits 16.

The external contacts 1, 2, 3, 4 provide the capability of selecting one of eight available increments of V_{ref}, depending upon the particular connections made. The lowest value of V_{ref} is determined by the DC voltage (V_{L}) applied to the base lead of the transistor Q15, which forms the positive input side of the differential amplifier 35. A feedback resistor R_{F}, provides negative feedback for the amplifier, and the product of its value and the least significant bit current determines increment values that the control devices 16 can adjust.

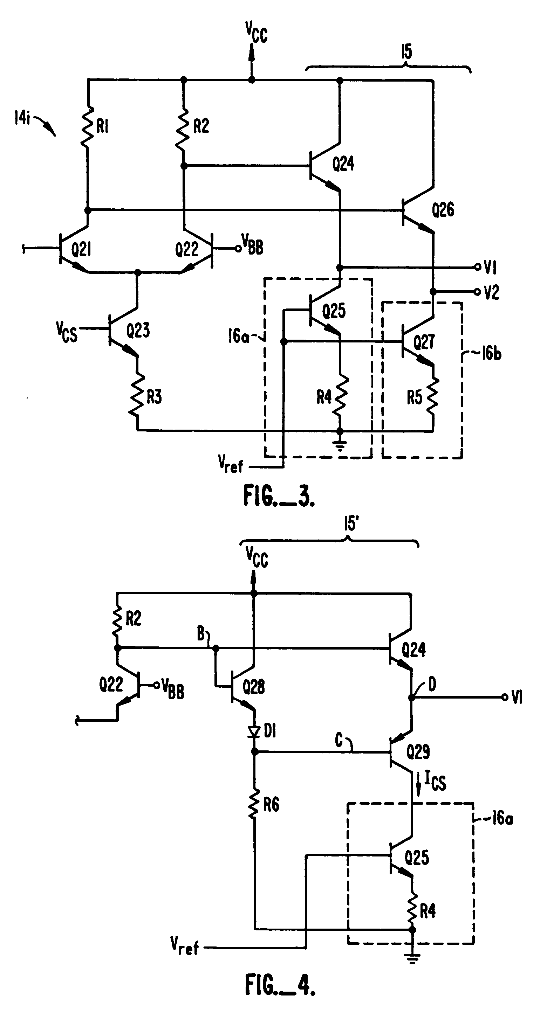

The present invention was developed for use in emitter-coupled logic (ECL) of the type having complementary data outputs, and output stages (drivers) being in the form of emitter followers. Illustrated in Fig. 3 is a representative ECL gate 14i having an output portion 15, and showing control devices 16a and 16b inserted in place of what normally would be the emitter resistance. The control devices 16a, 16b are identical in structure, function and operation. Accordingly, only the structure, function and operation of the control device 16a will be described, it being understood that any discussion of control device 16a will apply equally to control device 16b of Fig. 3.

As Fig. 3 shows, the control device 16a includes a transistor Q25 and a resistance R4 inserted in series between the emitter lead of the transistor Q24 and a ground potential. The transistor/resistor Q25/R4 combination form a current source that is controlled by the reference signal V_{ref} applied to the base terminal of the transistor Q25.

In operation, during post processing tests the signal propagation delays exhibited by the gates 14a, 14b, ... 14n formed on the integrated circuit chip 12 (Fig. 1) are determined. During this determination, the DAC 18 (Fig. 2) that is also formed on the integrated circuit chip generates a reference signal V_{ref} that is representative of the external contacts 1, 2, 3 floating, causing the corresponding base leads (of transistors Q4, Q8 and Q11) to be pulled to ground. If the measured signal propagation delay time is found to be higher than desired, the current-handling capability of the ouptut stages, including output stage 15 (Fig. 3), must be increased. Thus, depending upon the amount of increase needed, selected ones or all of external contacts 1, 2, 3 are connected to the supply voltage (via external contact 4) to produce a reference signal V_{ref} sufficient to cause the transistor Q25 of the control device 16a (and transistor Q27 of control device 16b - Fig. 3) to increase its conduction, increasing the current handling capability of the output stage 15.

Conversely, if post processing testing finds the signal propagation delay of the electronic circuits 14a - 14n less than desired (i.e., they are operating too fast), the current-handling capability of the output stages of the circuits must be reduced. Accordingly, a certain one or more of the external contacts 1, 2, 3 are connected to the external contact 4 (using low-temperature solder, for example) to obtain a V_{ref} sufficient to place the control device 16a in a current state that decreases the current-handling capability of the output stage of the corresponding gate, increasing the signal propagation time exhibited by that gate.

Fig. 4 illustrates the ability of a circuit in accordance with the present invention to provide active pull-down to sharpen the falling edges of the output signals produced by the output stages. This has advantages particularly when large interconnect distances and high capacitances are encountered. Fig. 4 shows only that portion of Fig. 3 that includes control device 16a, and identifies those elements of Fig. 3 that also appear in Fig. 4 with the same reference numerals. Added to that portion of the output stage 15 (Fig. 3) formed by transistors Q24 and Q25 are transistors Q28 and Q29, diode D1, and resistor R6. It should be understood that, although not specifically shown and described, a substantially similar circuit will be added to the output stage portion formed by transistors Q26, Q27.

Continuing with Fig. 4, transistor Q28 (which has its base lead connected to node B, the junction between resistor R2 and transistor Q22) forms a major current path with diode D1 and resistor R6 between V_{cc} and ground potential to bias transistor Q29 into a conductive state. As Fig. 4 further shows, transistor Q29, a PNP transistor, is connected in the current path formed by the transistor Q24 and Q25.

Transistor Q29 (and its associated bias circuitry) operates to actively pull-down or discharge any capacitive impedance that the output stage portion 15' must work into. Transistor Q29 has little or no effect on any rising edges of the output signal V1; it does, however, provide significant improvements on the falling edge of the output signal V1.

This improvement is achieved in the following manner: Transistor Q29 is biased by the bias circuit formed by the transistor Q28, diode D1, and resistor R6 (which has a value of approximately 30K-40K Ohms) to always be in the active state by node C being placed one diode drop below node D, thereby forward biasing the emitter-base junction of transistor Q29. Assume node B (input signal of transistor Q24) is at a high voltage level, placing the output voltage V1 in a high state. Assume further that the circuit of which Fig. 4 forms a part, has experienced a change of conditions so that node B (input signal of Q24) drops to a low voltage state. Node C will quickly follow the drop of node B to momentarily increase the forward bias of the base emitter junction of transistor Q29. Transistor Q29, thereby, provides a very high current discharge path to quickly discharge any capacitive output impedance. As the voltage at node D drops, transistor Q29 conducts less, until a quiescent state is achieved.

The circuitry shown in Fig. 4 does not affect low to high transitions of the output impedance V1 to any great extent - if at all. Even though a low to high voltage transition at node C may tend to push transistor Q29 toward cut-off, transistor Q24 will tend to compensate by "pumping" current into the output impedance.

As mentioned above, the present invention finds particular use in the output stages of digital gates and circuits implemented in ECL technology, and using emitter follower configuration output stages. As those skilled in the art are well aware, low to high output voltage transitions are typically much faster than the high to low transitions. To add the circuit of transistors Q28 and Q29, diode D1, and resistor R6, without the current source formed by the transistor Q25 and resistor R4 would not be effective. Thus, it is the addition of the control circuit 16a that provides the means and the basis for the addition of transistor Q29 and its associated advantages.

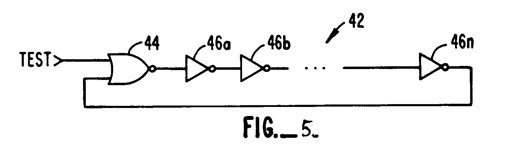

Illustrated in Fig. 5 is a test circuit 42 for use in determining the gate or signal propagation delays exhibited by the circuitry formed on an integrated circuit chip. As shown, the test circuit 42 is configured as a ring oscillator, comprising a two-input NOR gate 44 whose output is connected to a series-connected string of inverters 46a, 46b ... 46n. The output of the last inverter 46n is coupled back to one of the inputs of the two-input NOR gate 44, the other input receiving a TEST signal. The ring oscillator of test circuit 42 would also be formed on the integrated circuit chip 12 (Fig. 1) along with the DAC 18, and the control circuits 16 associated with the corresponding electronic circuits 14a, 14b ... 14n.

In operation, a known periodic TEST signal is applied to one input of the NOR gate 44, and the output of the inverter 46n monitored to determine the signal propagation delays of the electronic circuits formed on the integrated circuit chip 12. From this information a decision as to whether or not any adjustment of the current-handling capability of the output stages should be made and, if so, a determination of how much.

In summary, there has been disclosed a technique for regulating and "fine-tuning" the signal propagation delays of digital circuits, particularly those fabricated in integrated circuit form. And, while a preferred embodiment of the invention has been disclosed, it should be obvious that modifications and alterations can be made. For example, the DAC 18 (Fig. 2) can be programmed using fused links that replace the external contacts 1, 2, 3 (and 4), and tie the base circuits of transistors Q4, Q8 and Q11 to the supply voltage V_{cc}. During post-fabrication testing the fused-links can be interrupted (using laser-cutting, for example) to allow the associated base circuit to "float," allowing the corresponding base lead to be pulled to ground.

## Claims

1. Apparatus formed on a semiconductor chip fabricated to carry a plurality of electronic circuits, each of which includes a respective output stage having an output terminal for providing an output current thereat in response to an input signal applied to that output stage, the apparatus being adapted for regulation of the signal propagation delay exhibited by each of the electronic circuits and comprising:
for each said output stage, a first circuit means (16) coupled to that output stage and operable to limit the output current range in response to a common limit signal;
a second circuit means (18) coupled to each of the first circuit means (16) and presettable to provide a selected one of a number of reference signals as the common limit signal to all of those first circuit means; and
each output stage including a third circuit means operably coupled to that output stage, in series circuit configuration with the first circuit means (16) associated with that output stage, and adapted to provide an increased current handling capability during high to low transitions of the output current of that output stage.

2. Apparatus as claimed in claim 1, wherein each output stage includes an emitter follower transistor (Q24) having an emitter lead coupled to the first circuit means (16) and connected to the output terminal of that output stage for providing the output current thereat, said third means including a second transistor (Q29) inter coupling the emitter lead of said emitter follower transistor (Q24) and the first circuit means (16), and a control means (Q28, D1, R6) coupled to the second transistor (Q29) and being operable to sense a response time delay between an input signal applied to the base of the emitter follower transistor (Q24) and an output signal thereat to increase current conduction of the second transistor (Q29).

3. Apparatus as claimed in claim 2 wherein the emitter follower transistor (Q24) includes a base lead for receiving said input signal and said control means includes a third transistor (Q28) having a base lead connected to the base lead of the emitter follower transistor (Q24), and an emitter lead connected to a voltage potential (6Rd) via the series circuit of a diode (D1) and a resistor (R6) to develop a control signal which is connected to the second transistor (Q29) for controlling current conduction thereof.

4. Apparatus as claimed in claim 1, 2 or 3 wherein the reference signal is a voltage.

5. Apparatus as claimed in claim 1, 2 or 3 wherein the reference signal is a current.

6. Apparatus as claimed in claim 1, 2 or 3 wherein the second circuit means (18) includes a digital-to-analog conversion means operable to selectively provide the common limit signal.

7. Apparatus as claimed in claim 6, wherein the digital-to-analog conversion means includes a number of fused links capable of being selectively interrupted, the fused links forming said setting means.

8. Apparatus as claimed in claim 1, 2 or 3, wherein the setting means includes a plurality of contact elements and means for connecting the contact elements to one another to obtain said common limit signal.

9. Apparatus as claimed in claim 8, wherein the contact elements are capable of being connected in a number of interconnections, each interconnection obtaining a different value of the common limit signal.

10. Apparatus as claimed in claim 9, wherein one of the contact elements is coupled to a voltage potential and another of the contact elements in selectively connectible to said one of the contact elements to obtain the common limit signal.

11. Apparatus as claimed in claim 10, including packaging means forming an integrated circuit package containing the semiconductor chip, and means for making the contact elements accessible externally of the integrated circuit package.

12. Apparatus as claimed in claim 1, including test circuit means formed on the semiconductor chip for determining the signal propagation delay exhibited by the electronic circuits.

13. Apparatus as claimed in claim 12, wherein the test circuit includes a plurality of substantially identical signal propagating circuit means connected in series and having an input and an output, and means for feeding back the output to the input.

## Patentansprüche

1. Vorrichtung auf einem Halbleiterchip, der zum Tragen einer Vielzahl von elektronischen Schaltungen hergestellt ist, von denen jede eine entsprechende Ausgangsstufe mit einem dort angebrachten Ausgangsanschluß zur Lieferung eines Ausgangsstromes als Antwort auf ein an die Ausgangsstufe angelegtes Eingangssignal umfaßt, wobei die Vorrichtung für die Regulierung der Signalausbreitungsverzögerung ausgelegt ist, die bei jeder der elektronischen Schaltungen auftritt, und die Vorrichtung umfaßt:
für jede Ausgangsstufe eine erste Schaltungseinrichtung (16), die an die Ausgangsstufe angeschlossen und in der Lage ist, den Ausgangsstrombereich als Antwort auf ein gemeinsames Begrenzungssignal zu beschränken;
eine zweite Schaltungseinrichtung (18), die an jede erste Schaltungseinrichtung (16) angeschlossen und so voreinstellbar ist, daß sie ein ausgewähltes Signal einer Anzahl von Bezugssignalen als das gemeinsame Begrenzungssignal an alle genannten ersten Schaltungseinrichtungen liefert, und
wobei jede Ausgangsstufe eine dritte Schaltunseinrichtung umfaßt, die betrieblich an diese Ausgangsstufe in Reihenschaltung mit der ersten Schaltungseinrichtung (16) angeschlossen ist, welche dieser Ausgangsstufe zugeordnet ist, und die zur Schaffung eines gesteigerten Stromverarbeitungsvermögens während der Übergänge des Ausgangsstromes der Ausgangsstufe von hohem auf niedriges Niveau ausgelegt ist.

2. Vorrichtung nach Anspruch 1, bei der jede Ausgangsstufe einen Emitterfolgertransistor (Q24) mit einer Emitterzuleitung umfaßt, die mit der ersten Schaltungseinrichtung (16) verbunden und an die Ausgangsklemme der genannten Ausgangsstufe angeschlossen ist, um dort den Ausgangsstrom zu liefern, wobei die dritte Einrichtung einen zweiten Transistor (Q29), über den die Emitterzuleitung des Emitterfolgertransistors (Q24) und die erste Schaltungseinrichtung (16) verbunden werden, und eine Steuereinrichtung (Q28, D1, R6) aufweist, die mit dem zweiten Transistor (Q29) verbunden und in der Lage ist, eine Ansprechzeitverzögerung zwischen einem an die Basis des Emitterfolgertransistors (Q24) angelegten Eingangssignal, und einem dort auftretenden Ausgangssignal zu erfassen, um die Stromleitung des zweiten Transistors (Q29) zu erhöhen.

3. Vorrichtung nach Anspruch 2, bei der der Emitterfolgertransistor (Q24) eine Basiszuleitung zum Empfangen des genannten Eingangssignals umfaßt, und die genannte Steuereinrichtung einen dritten Transistor (Q28) mit einer Basiszuleitung umfaßt, die an die Basiszuleitung des Emitterfolgertransistors (Q24) angeschlossen ist, und mit einer Emitterzuleitung, die über die Serienschaltung bestehend aus einer Diode (D1) und einem Widerstand (R6) an ein Spannungspotential zur Entwicklung eines Steuersignals angeschlossen ist, das an den zweiten Transistor (Q29) zur Steuerung der Stromleitung desselben angelegt wird.

4. Vorrichtung nach Anspruch 1, 2 oder 3, wobei das Bezugssignal eine Spannung ist.

5. Vorrichtung nach Anspruch 1, 2 oder 3, wobei das Bezugssignal ein Strom ist.

6. Vorrichtung nach Anspruch 1, 2 oder 3, bei der die zweite Schaltungseinrichtung (18) eine Digital-Analog-Umwandlungseinrichtung umfaßt, die selektiv das gemeinsame Begrenzungssignal liefert.

7. Vorrichtung nach Anspruch 6, bei der die Digital-Analog-Umwandlungseinrichtung eine Anzahl von Schmelzverbindungen umfaßt, die selektiv unterbrochen werden können, wobei die Schmelzverbindungen die genannten Einstellmittel bilden.

8. Vorrichtung nach Anspruch 1, 2 oder 3, bei der die Einstellmittel eine Vielzahl von Kontaktelementen, und Mittel zum Miteinanderverbinden der Kontaktelemente aufweist, um das gemeinsame Begrenzungssignal zu erhalten.

9. Vorrichtung nach Anspruch 8, bei dem die Kontaktelemente in einer Anzahl von Zwischenverbindungen miteinander verbunden werden können, wobei jede Zwischenverbindung einen anderen Wert des gemeinsamen Begrenzungssignals ergibt.

10. Vorrichtung nach Anspruch 9, bei der eines der Kontaktelemente an ein Spannungspotential, und ein anderes der Kontaktelemente selektiv an das genannte eine Element der Kontaktelemente anschließbar ist, um das gemeinsame Begrenzungssignal zu erhalten.

11. Vorrichtung nach Anspruch 10, mit Umhüllungsmitteln, die ein Gehäuse für integrierte Schaltungen bilden, das das Halbleiterchip enthält, und mit Mitteln, die dazu dienen, die Kontaktelemente von außerhalb des genannten Gehäuses her zugänglich zu machen.

12. Vorrichtung nach Anspruch 1, mit einer Testschaltungseinrichtung auf dem Halbleiterchip zur Ermittlung der Signalausbeutungsverzögerung, die die elektronischen Schaltungen aufweisen.

13. Vorrichtung nach Anspruch 12, bei der die Testschaltung eine Vielzahl von im wesentlichen identischen Signalausbreitungsschaltungseinrichtungen, die in Reihe geschaltet sind und einen Eingang sowie einen Ausgang aufweisen, und Mittel zum Rückkoppeln der Ausgabe an den Eingang aufweist.

## Revendications

1. Dispositif formé sur une puce de semi-conducteur fabriquée pour porter une pluralité de circuits électroniques, dont chacun comprend un étage de sortie correspondant ayant une borne de sortie pour y fournir un courant de sortie en réponse à un signal d'entrée appliqué à cet étage de sortie, le dispositif étant propre à la régulation du temps de propagation des signaux présenté par chacun des circuits électroniques, et comprenant :
pour chaque étage de sortie, un premier moyen de circuit (16) connecté à cet étage de sortie et utilisable pour limiter la plage de courants de sortie en réponse à un signal de limitation commun ;
un second moyen de circuit (18) connecté à chacun desdits premiers moyens de circuit (16) et préréglable pour fournir un signal sélectionné parmi un certain nombre de signaux de référence, en tant que signal de limitation commun pour tous ces premiers moyens de circuit ; et
chaque étage de sortie comprenant un troisième moyen de circuit, connecté en service à cet étage de sortie, avec une configuration de circuit en série avec le premier moyen de circuit (16) associé à cet étage de sortie et propre à assurer une tenue de courant augmentée pendant les transitions du niveau haut au niveau bas du courant de sortie de cet étage de sortie.

2. Dispositif selon la revendication 1, dans lequel chaque étage de sortie comprend un transistor à montage émetteur-suiveur (Q24) ayant un conducteur d'émetteur connecté au premier moyen de circuit (16) et connecté à la borne de sortie de cet étage de sortie pour y fournir le courant de sortie, ledit troisième moyen comprenant un deuxième transistor (Q29) interconnectant le conducteur d'émetteur dudit transistor à montage émetteur-suiveur (Q24) et le premier moyen de circuit (16), et un moyen de commande (Q28, D1, R6) connecté au deuxième transistor (Q29) et étant utilisable pour détecter un temps de réponse entre un signal d'entrée appliqué à la base du transistor à montage émetteur-suiveur (Q24) et un signal de sortie au niveau de celui-ci, pour augmenter la conduction de courant du deuxième transistor (Q29).

3. Dispositif selon la revendication 2, dans lequel le transistor à montage émetteur-suiveur (Q24) comprend u conducteur de base pour recevoir ledit signal d'entrée, et dans lequel ledit moyen de commande comprend un troisième transistor (Q28) ayant un conducteur de base connecté au conducteur de base du transistor à montage émetteur-suiveur (Q24), et un conducteur d'émetteur-connecté à un potentiel de tension (6Rd) par l'intermédiaire du circuit série d'une diode (D1) et d'une résistance (R6) pour produire un signal de commande qui est connecté au deuxième transistor (Q29) pour commander la conduction de courant de celui-ci.

4. Dispositif selon la revendication 1, 2 ou 3 dans lequel le signal de référence est une tension.

5. Dispositif selon la revendication 1, 2 ou 3, dans lequel le signal de référence est un courant.

6. Dispositif selon la revendication 1, 2 ou 3 dans lequel le deuxième moyen de circuit (18) comprend un moyen de conversion numérique/analogique utilisable pour fournir sélectivement le signal de limitation commun.

7. Dispositif selon la revendication 6, dans lequel le moyen de conversion numérique/analogique comprend un certain nombre de connexions à fusibles propres à être sélectivement interrompues, les connexions à fusibles formant lesdits moyens de réglage.

8. Dispositif selon la revendication 1, 2 ou 3 dans lequel le moyen de réglage comprend une pluralité d'éléments de contact et des moyens pour connecter les éléments de contact entre eux pour obtenir ledit signal de limitation commun.

9. Dispositif selon la revendication 8, dans lequel les éléments de contact sont propres à être connectés en un certain nombre d'interconnexions, chaque interconnexion obtenant une valeur différente du signal de limitation commun.

10. Dispositif selon la revendication 9, dans lequel l'un des éléments de contact est connecté à un potentiel de tension et un autre des éléments de contact peut être connecté, de manière sélective, audit premier des éléments de contact pour obtenir le signal de limitation commun.

11. Dispositif selon la revendication 10, comprenant un moyen d'encapsulation formant un boîtier de circuit intégré contenant la puce de semi-conducteur, et un moyen pour rendre les éléments de contact accessibles à l'extérieur du boîtier de circuit intégré.

12. Dispositif selon la revendication 1, comprenant un moyen de circuit d'essai formé sur la puce de semiconducteur, pour déterminer le temps de propagation des signaux présenté par les circuits électroniques.

13. Dispositif selon la revendication 12, dans lequel le circuit d'essai comprend une pluralité de moyens de circuit de propagation de signaux, sensiblement identiques, montés en série et ayant une entrée et une sortie, et un moyen pour réinjecter la sortie à l'entrée.
